# EUROPÄISCHE PATENTSCHRIFT

(11) **EP 0 962 035 B1**
(45) Veröffentlichungstag und Bekanntmachung des Hinweises auf die Patenterteilung: **02.05.2003**
(21) Anmeldenummer: 98912273.4
(22) Anmeldetag: 18.02.1998
(51) Int. Cl.: H01S 5/02, G02B 6/42

(54) **LASERVORRICHTUNG**
LASER DEVICE
SYSTEME LASER

(30) Priorität: 18.02.1997 DE 19706279
(43) Veröffentlichungstag der Anmeldung: 08.12.1999
(73) Patentinhaber: Osram Opto Semiconductors GmbH & Co. OHG, 93049 Regensburg (DE)
(72) Erfinder: GRÖTSCH, Stefan, D-93053 Regensburg (DE)
(74) Vertreter: Epping, Wilhelm, Dipl.-Ing.
(86) Internationale Anmeldenummer: DE9800489
(87) Internationale Veröffentlichungsnummer: WO98037603

(56) Entgegenhaltungen:
- GB-A- 2 276 493
- US-A- 5 561 684
- PATENT ABSTRACTS OF JAPAN vol. 006, no. 164 (E-127), 27.August 1982 & JP 57 084189 A (NEC CORP), 26.Mai 1982,
- PATENT ABSTRACTS OF JAPAN vol. 015, no. 323 (E-1101), 16.August 1991 & JP 03 120884 A (HITACHI LTD), 23.Mai 1991,
- PATENT ABSTRACTS OF JAPAN vol. 010, no. 008 (E-373), 14.Januar 1986 & JP 60 171780 A (HITACHI SEISAKUSHO KK), 5.September 1985,
- PATENT ABSTRACTS OF JAPAN vol. 005, no. 198 (E-087), 16.Dezember 1981 & JP 56 120177 A (TOSHIBA CORP), 21.September 1981,

## Beschreibung

Die Erfindung bezieht sich auf eine Laservorrichtung, bei der ein eine Laserstrahlung aussendender Körper und mindestens ein Element zur Strahlführung oder Strahlabbildung der Laserstrahlung in einem gemeinsamen Gehäuse angeordnet sind. Es bezieht sich insbesondere auf eine Laservorrichtung mit einem Halbleiterlaserchip, insbesondere einem Leistungs-Halbleiterlaser-Barren, und einer Zylinderlinse zur Fokussierung der von dem Halbleiterlaserchip ausgesandten Laserstrahlung, bei der der Halbleiterlaserchip auf einem Grundträgerteil befestigt und die Zylinderlinse vor einer Strahlaustrittsfläche des Halbleiterlaserchips angeordnet ist.

Bislang wird bei derartigen Vorrichtungen das Element zur Strahlführung (z. B. ein Lichtwellenleiter) oder Strahlabbildung (z. B. eine Linse und/oder ein Spiegel) meist sehr aufwendig mittels eines Glaslotes oder eines metallischen Lotes im Gehäuse befestigt.

PATENT ABSTRACTS OF JAPAN vol. 006, no. 164 (E-127), 27. August 1982; & JP 57 084189 A (NEC CORP), 26. Mai 1982, beschreibt eine Halbleiterlaservorrichtung gemäß dem Oberbegriff des Anspruchs 1. Zur Lagerung der Zylinderlinse ist in dieser bekannten Vorrichtung eine V-förmige Nut vorgesehen. PATENT ABSTRACTS OF JAPAN vol. 005, no. 198 (E-087), 16. Dezember 1981; & JP 56 120177 A (TOSHIBA CORP), 21. September 1981, beschreibt eine Vorrichtung, bei der ein Licht aussendender Halbleiterkörper und eine sphärische Linse in einem gemeinsamen Gehäuse angeordnet sind, wobei die Linse mittels einer Silikonschicht in dem Gehäuse befestigt ist.

Der vorliegenden Erfindung liegt die Aufgabe zu Grunde, eine Laservorrichtung der eingangs genannten Art zu entwickeln, die eine einfachere Montage des Elements zur Strahlführung oder Strahlabbildung ermöglicht und bei der ein Verbindungsmittel zwischen dem Element und dessen Montagefläche vorgesehen ist, das hohe Dehnungen ohne plastisches Ermüden übersteht und Laserbestrahlung sehr gut standhält.

Diese Aufgabe wird durch eine Laservorrichtung mit den Merkmalen des Anspruches 1 gelöst.

Erfindungsgemäß ist das Element zur Strahlführung oder Strahlabbildung mittels Silikon in dem Gehäuse befestigt ist. Vorteilhafte Weiterbildungen der erfindungsgemäßen Laservorrichtung sind Gegenstand der Unteransprüche 2 bis 10.

Bei einer besonders bevorzugten Ausführungsform der Laservorrichtung, bei dem der eine Laserstrahlung aussendende Körper ein Halbleiterlaserchip ist, ist das zwischen dem Halbleiterlaserchip und dem Grundträgerteil vorgesehene Zwischenträgerteil ein Molybdän-Anschlussrahmen, der mittels phototechnischem Strukturieren einer auf dem Grundträgerteil aufgebrachten Molybdänschicht (z. B. Sputter-, Aufdampf- oder Galvanikschicht) hergestellt ist oder als vorgefertigtes Teil (als Leadframe) auf dem Grundträgerteil beispielsweise mittels einer Hartlotschicht befestigt ist. Dies hat den besonderen Vorteil, dass mechanische Spannungen auf Grund von unterschiedlichen thermischen Ausdehnungen des Halbleiterlaserchips und des Grundträgerteils, das beispielsweise als Wärmesenke dient und z. B. aus Kupfer besteht, größtenteils von dem Zwischenträgerteil kompensiert werden, da Molybdän aufgrund seines hohen Elastizitätsmoduls die mechanischen Spannungen im elastischen Dehnungsbereich aufnimmt. An Stelle von Molybdän kann selbstverständlicherweise auch ein anderer elektrisch leitender Werkstoff mit einem hohen Elastizitätsmodul, hoher Fließspannung und hoher Temperaturbeständigkeit verwendet sein. Als Beispiele wären hier W, CuW- und CuMo-Legierungen (Cu-Anteil jeweils zwischen 10 und 20%) zu nennen. Alle oben genannten Materialen lassen sich sowohl als Folie als auch als Sputter-, Aufdampf- oder Galvanikschicht herstellen und weisen eine gute Wärmeleitfähigkeit auf.

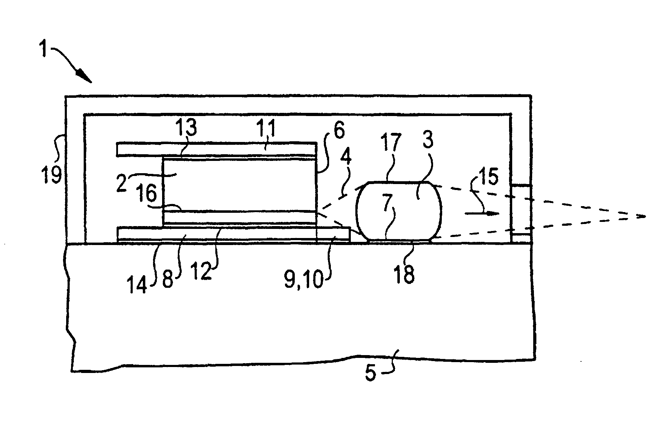

Die erfindungsgemäße Laservorrichtung wird im folgenden anhand eines Ausführungsbeispieles in Verbindung mit der Figur näher erläutert. Die Figur zeigt eine schematische Darstellung eines senkrechten Schnittes durch das Ausführungsbeispiel.

Bei dem Ausführungsbeispiel ist auf einem Grundträgerteil 5 eines Gehäuses 19 ein Zwischenträgerteil 8 befestigt, auf dem sich ein Halbleiterlaserchip 2 befindet. Das Grundträgerteil 5 besteht beispielsweise aus Kupfer und das Zwischenträgerteil 8 aus Molybdän. Der Halbleiterlaserchip 2 ist beispielsweise ein Leistungs-Halbleiterlaser-Barren, der im Betrieb eine Mehrzahl von im Querschnitt streifenförmigen, auf einer Geraden nebeneinander angeordneten Einzellaserstrahlen 4 aussendet und aus AlₓGa₁₋ₓAs (0 ≤ x ≤ 1) besteht. Dieser Halbleiterlaserchip 2 ist beispielsweise mittels einer Hartlotschicht 12 (z. B. bestehend aus Au-Sn-Lot) mit dem Zwischenträgerteil 8 verbunden.

Auf der Oberseite des Halbleiterlaserchips 2 ist eine Anschlussplatte 11 befestigt, die als zweiter elektrischer Anschluss für den Halbleiterlaserchip 2 vorgesehen ist. Die Anschlussplatte 11 besteht bevorzugt aus demselben Material wie das Zwischenträgerteil 8 und ist z. B. ebenfalls mittels einer Hartlotschicht 13 (z. B. bestehend aus Au-Sn-Lot) auf dem Halbleiterlaserchip 2 befestigt.

Im Falle eines getrennt vom Grundträgerteil 5 hergestellten Zwischenträgerteiles 8 ist dieses ebenfalls bevorzugt mittels einer Hartlotschicht 14 auf dem Grundträgerteil 5 befestigt.

Am Zwischenträgerteil 8 sind zwei Abstandhalterteile 9,10 ausgebildet, die sich ausgehend von einer Strahlaustrittsfläche 6 des Halbleiterchips 2 in Richtung Strahlausbreitungsrichtung 15 der Laserstrahlung 4 erstrecken und einen Abstand voneinander aufweisen, der größer ist als die Breite der Strahlaustrittsfläche 6, so dass die Laserstrahlung 4 von den Abstandhalterteilen 9,10 nicht beeinträchtigt wird.

Auf dem Grundträgerteil 5 ist weiterhin eine Zylinderlinse 3 angeordnet, die auf gegenüberliegenden Seiten abgeflachte Seitenflächen 7,17 aufweist. Die Zylinderlinse 3 liegt mit einer der abgeflachten Seitenflächen 7 auf dem Grundträgerteil 5 auf und mit einer der Strahlaustrittsfläche 6 des Halbleiterlaserchip 2 zugewandten gekrümmten Seitenfläche an den beiden Abstandhalterteilen 9,10 an und ist mittels einer Silikonschicht 18 auf dem Grundträgerteil 5 befestigt. Silikon-Klebstoffe halten Laserbestrahlung sehr gut stand und überstehen unbeschadet sehr hohe Dehnungen ohne plastisches Ermüden.

Zur Herstellung der oben beschriebenen Zylinderlinsen 3 werden beispielsweise längere Glasfaserstücke von zwei gegenüberliegenden Seiten her beispielsweise mittels Schleifen abgeflacht und anschließend beispielsweise mittels Sägen zu einzelnen Zylinderlinsen zertrennt.

Um die Strahlein- und Strahlauskoppelflächen der Zylinderlinsen 3 optisch zu vergüten, können die Glasfaserstücke zum Beispiel in einer Horde übereinandergestapelt und von beiden Seiten mit einer herkömmlichen optischen Vergütungsschicht versehen werden. Durch die abgeflachten Seitenflächen ist sichergestellt, dass die vergüteten Flächen bei der weiteren Handhabung der Zylinderlinsen 3 nicht verdreht werden.

Die Zylinderlinse 3 ist derart angeschliffen, dass ihr Scheitel genau auf der Höhe des strahlungsemittierenden Bereiches 16 des auf dem Zwischenträgerteil 8 befestigten Halbleiterlaserchips 2 liegt. Der Fokus zwischen dem Halbleiterlaserchip 2 und der Zylinderlinse 3 ist durch die Abstandhalterteile 9,10 des Zwischenträgerteiles 8 fest vorgegeben.

Ein besonderer Vorteil der erfindungsgemäßen Laservorrichtung 1 besteht darin, dass die Zylinderlinse 3 ohne den Halbleiterlaserchip 2 zu betreiben, gegenüber dem Halbleiterlaserchip 2 justiert und anschließend auf das Grundträgerteil 5 montiert werden kann und nicht mehr in mehreren Freiheitsgraden ausgerichtet werden muss.

Die Erläuterung der erfindungsgemäßen Laservorrichtung anhand des obigen Ausführungsbeispieles ist selbstverständlicherweise nicht als Einschränkung der Erfindung auf diese spezielle Ausführungsform zu verstehen.

## Patentansprüche

1. Laservorrichtung (1), bei der ein eine Laserstrahlung (4) aussendender Körper (2) und mindestens ein Element (3) zur Strahlführung und/oder Strahlabbildung in einem gemeinsamen Gehäuse (19) angeordnet sind, wobei der Körper (2) ein Halbleiterlaserchip ist und das Element zur Strahlführung und/oder Strahlabbildung eine Zylinderlinse (3) ist, **dadurch gekennzeichnet, daß** die Zylinderlinse mittels einer Silikonschicht (18) in dem Gehäuse (19) befestigt ist und eine abgeflachte Seitenfläche (7) aufweist, mit der die Zylinderlinse (3) auf einem Grundträgerteil (5) aufliegt.

2. Laservorrichtung (1) nach Anspruch 1,
**dadurch gekennzeichnet, daß**
der eine Laserstrahlung (4) aussendenden Körper (2) und das Element zur Strahlführung oder Strahlabbildung gemeinsam auf dem Grundträgerteil (5) befestigt sind, derart, daß das Element (3) vor der Strahlaustrittsfläche (6) des Körpers (2) angeordnet ist.

3. Laservorrichtung (1) nach Anspruch 1 oder 2,
**dadurch gekennzeichnet, daß**
die Zylinderlinse die von dem Halbleiterlaserchip ausgesandte Laserstrahlung (4) fokussiert.

4. Laservorrichtung (1) nach einem der Ansprüche 1 bis 3,
**dadurch gekennzeichnet, daß**
die Zylinderlinse (3) aus einer Glasfaser gefertigt ist.

5. Laservorrichtung (1) nach einem der Ansprüche 1 bis 4,
**dadurch gekennzeichnet, daß**
der Halbleiterlaserchip (2) ein Leistungs-Halbleiterlaser-Barren ist.

6. Halbleiterlaservorrichtung (1) nach einem der Ansprüche 1 bis 5,
**dadurch gekennzeichnet, daß**
zwischen dem Halbleiterlaserchip (2) und dem Grundträgerteil (5) ein Zwischenträgerteil (8) vorgesehen ist, das mindestens zwei Abstandshalterteile (9, 10) aufweist, die als Justageanschlag für die Zylinderlinse (3) dienen.

7. Halbleiterlaservorrichtung (1) nach einem der Ansprüche 1 bis 6,
**dadurch gekennzeichnet, daß**
die Zylinderlinse (3) an zwei einander gegenüberliegenden Seiten abgeflacht ist.

8. Halbleiterlaservorrichtung (1) nach einem der Ansprüche 6 bis 7,
**dadurch gekennzeichnet, daß**
der Abstand zwischen den beiden Abstandhalterteilen (9, 10) größer ist als die Breite der Strahlaustrittsfläche (6) des Halbleiterlaserchips (2).

9. Halbleiterlaservorrichtung (1) nach einem der Ansprüche 6 bis 8,
**dadurch gekennzeichnet, daß**
das Zwischenträgerteil (8) Molybdän, CuW oder CuMo aufweist.

10. Halbleiterlaservorrichtung (1) nach einem der Ansprüche 6 bis 9,
**dadurch gekennzeichnet, daß**
ein Fokus zwischen dem Halbleiterlaserchip und der Zylinderlinse (3) durch die Länge der Abstandhalterteile (9, 10) des Zwischenträgerteiles (8) fest vorgegeben ist.

## Claims

1. Laser device (1), in which a component (2) emitting laser radiation (4) and at least one element (3) for beam guidance and/or beam projection are arranged in a common housing (19), the component (2) being a semiconductor laser chip and the element for beam guidance and/or beam projection being a cylindrical lens (3) **characterized in that** the cylindrical lens is attached in the housing (19) by means of a layer (18) of silicone and has a flattened side face (7), by way of which it bears on a base carrier part (5).

2. Laser device (1) according to Claim 1, **characterized in that** the component (2) emitting laser radiation (4) and the element for beam guidance or beam projection are attached jointly to the base carrier part (5), in such a manner that the element (3) is arranged in front of the beam-emergence surface (6) of the component (2).

3. Laser device (1) according to Claim 1 or 2, **characterized in that** the cylindrical lens focuses the laser radiation (4) emitted by the semiconductor laser chip.

4. Laser device (1) according to one of Claims 1 to 3, **characterized in that** the cylindrical lens (3) is made from a glass fibre.

5. Laser device (1) according to one of Claims 1 to 4, **characterized in that** the semiconductor laser chip (2) is a linear array of power semiconductor lasers.

6. Semiconductor laser device (1) according to one of Claims 1 to 5, **characterized in that** an intermediate carrier part (8) is provided between the semiconductor laser chip (2) and the base carrier part (5), which intermediate carrier part has at least two spacer parts (9, 10) which serve as an adjustment stop for the cylindrical lens (3).

7. Semiconductor laser device (1) according to one of Claims 1 to 6, **characterized in that** the cylindrical lens is flattened on two mutually opposite sides.

8. Semiconductor laser device (1) according to one of Claims 6 to 7, **characterized in that** the distance between the two spacer parts (9, 10) is greater than the width of the beam emergence surface (6) of the semiconductor laser chip (2).

9. Semiconductor laser device (1) according to one of Claims 6 to 8, **characterized in that** the intermediate carrier part (8) contains molybdenum, CuW or CuMo.

10. Semiconductor laser device (1) according to one of Claims 6 to 9, **characterized in that** a focus between the semiconductor laser chip and the cylindrical lens (3) is fixedly predetermined by the length of the spacer parts (9, 10) of the intermediate carrier part (8).

## Revendications

1. Dispositif laser (1), dans lequel un corps (2) émettant un rayonnement laser (4) et au moins un élément (3) pour le guidage du rayonnement et/ou la projection du rayonnement sont disposés dans un boîtier commun (19), dans lequel le corps (2) est une puce laser à semi-conducteur et l'élément pour la guidage du rayonnement et/ou la projection du rayonnement est une lentille cylindrique (3), **caractérisé en ce que** la lentille cylindrique est fixée dans le boîtier (19) au moyen d'une couche de silicone (18) et présente une face latérale aplatie (7), avec laquelle la lentille cylindrique (3) est posée sur une pièce portante de fond (5).

2. Dispositif laser (1) suivant la revendication 1, **caractérisé en ce que** le corps (2) émettant un rayonnement laser (4) et l'élément pour le guidage du rayonnement ou la projection du rayonnement sont fixés ensemble sur la pièce portante de fond (5), de telle manière que l'élément (3) est disposé devant la face de sortie du rayonnement (6) du corps (2).

3. Dispositif laser (1) suivant la revendication 1 ou 2, **caractérisé en ce que** la lentille cylindrique focalise le rayonnement laser (4) émis par la puce laser à semi-conducteur.

4. Dispositif laser (1) suivant l'une quelconque des revendications 1 à 3, **caractérisé en ce que** la lentille cylindrique (3) est fabriquée d'une fibre de verre.

5. Dispositif laser (1) suivant l'une quelconque des revendications 1 à 4, **caractérisé en ce que** la puce laser à semi-conducteur (2) est un barreau laser de puissance à semi-conducteur.

6. Dispositif laser à semi-conducteur (1) suivant l'une quelconque des revendications 1 à 5, **caractérisé en ce qu'**il est prévu entre la puce laser à semi-conducteur (2) et la pièce portante de fond (5) une pièce portante intermédiaire (8), qui présente au moins deux pièces d'écartement (9, 10), qui servent de butée d'ajustage pour la lentille cylindrique (3).

7. Dispositif laser à semi-conducteur (1) suivant l'une quelconque des revendications 1 à 6, **caractérisé en ce que** la lentille cylindrique (3) est aplatie sur deux faces opposées l'une à l'autre.

8. Dispositif laser à semi-conducteur (1) suivant l'une ou l'autre des revendications 6 et 7, **caractérisé en ce que** la distance entre les deux pièces d'écartement (9, 10) est plus grande que la largeur de la face de sortie du rayonnement (6) de la puce laser à semi-conducteur (2).

9. Dispositif laser à semi-conducteur (1) suivant l'une quelconque des revendications 6 à 8, **caractérisé en ce que** la pièce portante intermédiaire (8) présente du molybdène, du CuW ou du CuMo.

10. Dispositif laser à semi-conducteur (1) suivant l'une quelconque des revendications 6 à 9, **caractérisé en ce qu'**un foyer entre la puce laser à semi-conducteur et la lentille cylindrique (3) est prédéfini fermement par la longueur des pièces d'écartement (9, 10) de la pièce portante intermédiaire (8).
